(19) Europäisches Patentamt / European Patent Office / Office européen des brevets

(11) **EP 3 220 156 B1**

(12) **EUROPEAN PATENT SPECIFICATION**

(45) Date of publication and mention of the grant of the patent:
**15.09.2021 Bulletin 2021/37**

(51) Int Cl.:
*G01R 33/00* (2006.01)    *G01R 33/09* (2006.01)
*G01B 7/16* (2006.01)    *G01L 1/22* (2006.01)

(21) Application number: **17158794.2**

(22) Date of filing: **02.03.2017**

(54) **SENSOR DEVICE**

SENSORVORRICHTUNG

DISPOSITIF DE CAPTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.03.2016 JP 2016050722**

(43) Date of publication of application:
**20.09.2017 Bulletin 2017/38**

(73) Proprietor: **Alps Alpine Co., Ltd.**
**Tokyo**
**145-8501 (JP)**

(72) Inventor: **Kawahata, Ken**
**145-8501 Ota-ku, Tokyo (JP)**

(74) Representative: **Schmitt-Nilson Schraud Waibel Wohlfrom**
**Patentanwälte Partnerschaft mbB**
**Pelkovenstraße 143**
**80992 München (DE)**

(56) References cited:
**US-A- 4 911 016          US-A- 5 460 050**
**US-A1- 2004 200 260**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a sensor device which detects a physical quantity by a bridge circuit and in particular, to a sensor device in which offset adjustment of the output of a bridge circuit is possible.

There is a sensor element of a type in which a resistance value changes according to a physical quantity, such as a pressure sensor or a magnetic sensor, for example. In a case of obtaining the detection value of a physical quantity by this type of sensor element, a bridge circuit is generally used. An offset voltage is generated in the output of the bridge circuit due to variation in the resistance value of the sensor element, and therefore, in order to obtain a highly accurate detection value over a wide range, adjustment of the offset voltage in an analog circuit is required. Japanese Unexamined Patent Application Publication No. 1-311284 discloses a method of adjusting an offset voltage by inserting a resistor in parallel or in series to a sensor element. Further, Japanese Unexamined Patent Application Publication No. 1-311284 discloses a method of adjusting the offset voltage by adding voltage to the output of the bridge circuit.

Documents US4911016 and US5460050 disclose other examples of sensor devices having means for adjusting an offset voltage.

In a case where a resistor for the adjustment of the offset voltage is formed in an IC, since variation in resistance value for each manufacturing lot occurs by about several tens of percent, there is a problem in which the adjustment range of the offset voltage varies for each manufacturing lot. Further, there is also a problem in which the output sensitivity of the bridge circuit varies due to variation in the resistor for adjustment.

Furthermore, a temperature characteristic differs between the resistor for adjustment and the sensor element, and therefore, even if the adjustment of the offset voltage is performed at a certain temperature, there is a problem in which fluctuation (drift) of the offset voltage occurs according to a change in temperature. It is difficult to perfectly match the temperature characteristics of the sensor element and the resistor with each other, and as a result, the temperature characteristic of the offset voltage deteriorates.

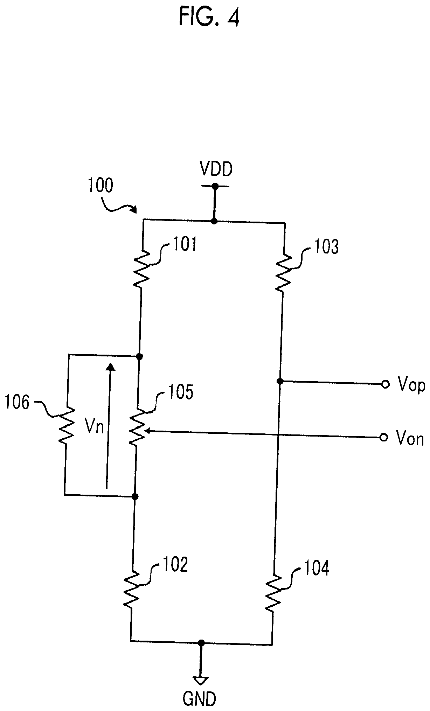

Fig. 4 is a diagram showing a general bridge circuit 100 having a variable resistor (a potentiometer) 105 for offset adjustment.

In the bridge circuit 100 shown in Fig. 4, each of a series circuit of a resistor 101 and a resistor 102 and a series circuit of a resistor 103 and a resistor 104 is connected between a power supply voltage VDD and a ground GND. The variable resistor 105 is inserted in an intermediate pathway connecting the resistor 101 and the resistor 102. A resistor 106 is a resistor for temperature compensation and is connected in parallel with the variable resistor 105. The difference between voltage Vop of an intermediate node to which the resistors 103 and 104 are connected and voltage Von of an intermediate terminal of the variable resistor 105 becomes the output voltage of the bridge circuit 100.

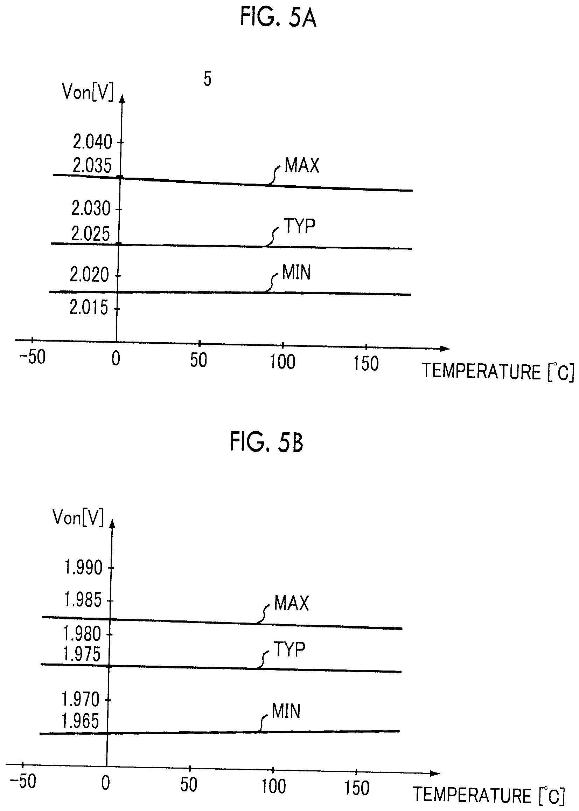

Figs. 5A and 5B are diagrams showing the simulation result of output performed on the bridge circuit 100 shown in FIG. 4 and show variation in the voltage Von on one side on which the variable resistor 105 is provided, and a change in temperature. Fig. 5A shows an upper limit value in an adjustment range, and Fig. 5B shows a lower limit value in the adjustment range. "TYP" in each drawing indicates a representative value, "MAX" indicates the maximum value of variation, and "MIN" indicates the minimum value of variation. In this simulation, the resistance values of the four resistors 101, 102, 103, and 104 configuring the bridge circuit 100 are 2000 [$\Omega$] and the temperature coefficient is 1860 [ppm/°C]. The variable resistor 105 is configured by connecting 32 resistors in series, and the resistance value of each resistor is 2.36 [$\Omega$] and the temperature coefficient is 2900 [ppm/°C]. The resistance value of the resistor 106 for temperature compensation is 126.6 [$\Omega$] and the temperature coefficient is 1300 [ppm/°C].

In the simulation of Figs. 5A and 5B, the power supply voltage VDD is 4 [V], and the adjustment range of the voltage Von in designing is $2 \pm 0.025$ [V]. However, due to the manufacturing variation of the resistance value, the adjustment range greatly varies from $\pm 0.018$ [V] to $\pm 0.035$ [V]. Further, in spite of the resistor 106 for temperature compensation being provided, a large change in the voltage Von due to a temperature occurs.

The present invention provides a sensor device in which it is possible to suppress variation in an offset adjustment range of a bridge circuit due to the influence of manufacturing variation or the like.

A sensor device according to an aspect of the present invention is described in appended claim 1.

According to this configuration, the voltage between the nodes at both ends in the voltage dividing circuit is kept constant. For this reason, even if manufacturing variation is present in the impedance of the plurality of impedance elements, the range of change of the voltage of the output node due to adjustment of the voltage dividing ratio becomes substantially constant. In this way, also with respect to the voltage between the output node of the voltage dividing circuit in the series circuit on one side and the intermediate node of the series circuit on the other side, or the voltage between the output node of the voltage dividing circuit in the series circuit on one side and the output node on the other side of the voltage dividing circuit on the other side in the series circuit on the other side, the range of change due to the adjustment of the voltage dividing ratio becomes substantially constant. Accordingly, even if manufacturing variation is present in the impedance of the plurality of impedance elements, the adjustment range of the offset becomes substantially constant, and thus variation is suppressed.

Preferably, the constant voltage circuit includes a variable resistance element which is connected in parallel with the voltage dividing circuit and has a resistance value changing according to a control signal, a differential amplifier circuit which amplifies the voltage between the nodes at both ends in the voltage dividing circuit, and an error amplifier circuit which amplifies a difference between an output voltage of the differential amplifier circuit and a reference voltage and outputs the control signal according to the amplification result.

According to this configuration, the voltage between the nodes at both ends in the voltage dividing circuit is amplified in the differential amplifier circuit, the difference between the output voltage of the differential amplifier circuit and the reference voltage is amplified in the error amplifier circuit, and the control signal according to the amplification result is output from the error amplifier circuit. The resistance value of the variable resistance element connected in parallel with the voltage dividing circuit changes according to the control signal, whereby the voltage between the nodes at both ends of the voltage dividing circuit is kept constant.

Preferably, the differential amplifier circuit outputs the voltage obtained by adding the voltage resulting from the amplification of the voltage between the nodes at both ends in the voltage dividing circuit and a common mode voltage kept constant.

According to this configuration, the voltage between the nodes at both ends of the voltage dividing circuit is kept at a constant voltage according to the gain of the differential amplifier circuit, the reference voltage, and the common mode voltage.

Preferably, in the voltage dividing circuit, a resistance value between the nodes at both ends is constant and a resistance value between the node on one side in the nodes at both ends and the output node and a resistance value between the node on the other side in the nodes at both ends and the output node are adjustable.

According to this configuration, by adjusting the resistance value between the node on one side in the nodes at both ends and the output node and the resistance value between the node on the other side in the nodes at both ends and the output node, it becomes possible to adjust the voltage dividing ratio. Further, since the resistance value between the nodes at both ends is constant, the voltage which is applied to the impedance element hardly changes by the adjustment of the voltage dividing ratio. In this way, the sensitivity of converting a change in physical quantity into a change in impedance in the impedance element is hardly affected by the adjustment of the voltage dividing ratio.

Preferably, a constant voltage is supplied to the two nodes, and in the plurality of impedance elements, temperature coefficients of impedance are uniform.

According to this configuration, since the temperature coefficients of impedance in the plurality of impedance elements are uniform, it is difficult for the ratio of the impedance in the plurality of impedance elements to change according to a temperature. Further, since a constant voltage is supplied to the two nodes and the voltage between the nodes at both ends of the voltage dividing circuit is kept constant, if it is difficult for the ratio of the impedance in the plurality of impedance elements to change according to a temperature, the voltage which is applied to the plurality of impedance elements is also difficult to change according to a temperature. Accordingly, it is difficult for the offset of the output voltage of the bridge circuit to change according to a temperature.

According to the present invention, it is possible to suppress variation in an offset adjustment range of the bridge circuit due to the influence of manufacturing variation or the like.

BRIEF DESCRIPTION OF THE DRAWINGS

Fig. 1 is a diagram showing an example of a configuration of a sensor device according to an embodiment of the present invention;
Figs. 2A and 2B are diagrams showing a simulation result of output performed on the sensor device shown in Fig. 1, in which Fig. 2A shows an upper limit value in an adjustment range and Fig. 2B shows a lower limit value in the adjustment range;
Fig. 3 is a diagram showing a configuration of a sensor device according to another embodiment of the present invention;
Fig. 4 is a diagram showing a bridge circuit having a variable resistor for offset adjustment; and
Figs. 5A and 5B are diagrams showing a simulation result of output performed on the bridge circuit shown in Fig. 4, in which Fig. 5A shows an upper limit value in an adjustment range and Fig. 5B shows a lower limit value in the adjustment range.

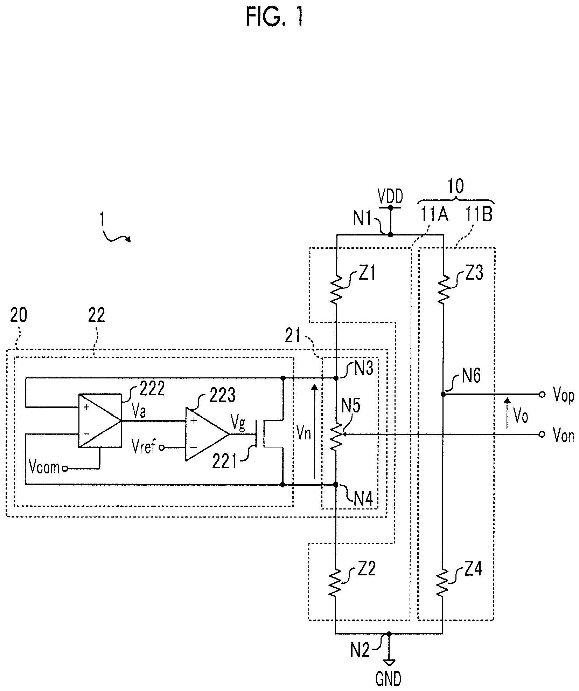

Fig. 1 is a diagram showing an example of the configuration of a sensor device 1 according to an embodiment of the present invention. The sensor device 1 shown in Fig. 1 is provided with a bridge circuit 10 having four impedance elements Z1 to Z4, and an offset adjustment circuit 20 for adjusting the offset of the output voltage of the bridge circuit 10.

The impedance elements Z1 to Z4 (hereinafter, they are sometimes referred to as an "impedance element Z" without distinction) are elements (sensor elements) each having impedance according to a physical quantity of a detection target, such as a magnetic field, a temperature, or pressure, for example. In this embodiment, the temperature coefficients of the four impedance elements Z1 to Z4 are uniform.

The bridge circuit 10 has two series circuits 11A and 11B. Each of the series circuits 11A and 11B includes two impedance elements Z connected in series between two nodes N1 and N2. The series circuit 11A includes the impedance elements Z1 and Z2, and the series circuit 11B includes the impedance elements Z3 and Z4. The node N1 is connected to a power supply line VDD, and the node N2 is connected to a ground GND. A power supply voltage which is the difference between the potential of the power supply line and the potential of the ground is applied between the two nodes N1 and N2. It is preferable that the power supply voltage keeps a constant voltage without fluctuation.

In the impedance element Z1, a terminal on one side is connected to the node N1 and a terminal on the other side is connected to a terminal on one side of the impedance element Z2 through a voltage dividing circuit 21 (described later). A terminal on the other side of the impedance element Z2 is connected to the node N2. In the impedance element Z3, a terminal on one side is connected to the node N1 and a terminal on the other side is connected to a terminal on one side of the impedance element Z4. A terminal on the other side of the impedance element Z4 is connected to the ground GND.

In the example of Fig. 1, the offset adjustment circuit 20 has the voltage dividing circuit 21 and a constant voltage circuit 22.

The voltage dividing circuit 21 is inserted in an intermediate pathway (a pathway connecting the two impedance elements Z1 and Z2) of the series circuit 11A, and divides voltage between nodes N3 and N4 at both ends in the inserted intermediate pathway and outputs the divided voltage from an output node N5. In the voltage dividing circuit 21, a resistance value between the nodes N3 and N4 at both ends is constant and a resistance value between the node N3 and the output node N5 and a resistance value between the node N4 and the output node N5 are adjustable.

The voltage dividing circuit 21 is configured using, for example, a variable resistor (a potentiometer). Specifically, the voltage dividing circuit 21 is configured to include a plurality of resistors connected in series between the nodes N3 and N4, and a multiplexer which selects one of intermediate nodes of these resistors connected in series and connects it to the output node N5. The voltage dividing ratio of the voltage dividing circuit 21 is adjusted by switching the selection of the intermediate node by the multiplexer.

The constant voltage circuit 22 keeps voltage Vn between the nodes N3 and N4 at both ends in the voltage dividing circuit 21 constant. The constant voltage circuit 22 shown in Fig. 1 includes a variable resistance element 221, a differential amplifier circuit 222, and an error amplifier circuit 223.

The variable resistance element 221 is connected in parallel with the voltage dividing circuit 21, and a resistance value thereof changes according to a control signal Vg which is outputted from the error amplifier circuit 223. In the example of Fig. 1, the variable resistance element 221 is an n-type MOS transistor, and the drain thereof is connected to the node N3, the source thereof is connected to the node N4, and the control signal Vg is input to the gate thereof. The variable resistance element 221 is not limited to the MOS transistor and may be another type of transistor (a bipolar transistor or the like).

The differential amplifier circuit 222 amplifies the voltage Vn between the nodes N3 and N4 at both ends in the voltage dividing circuit 21. For example, the differential amplifier circuit 222 outputs voltage Va obtained by adding the voltage resulting from the amplification of the voltage Vn between the nodes N3 and N4 at both ends in the voltage dividing circuit 21 and a common mode voltage Vcom kept constant. If the gain of the differential amplifier circuit 222 is set to be G, the output voltage Va of the differential amplifier circuit 222 is expressed by the following expression.

$$Va=G \cdot Vn+Vcom \quad \ldots (1)$$

The error amplifier circuit 223 amplifies the difference between the output voltage Va of the differential amplifier circuit 222 and a reference voltage Vref and outputs the control signal Vg according to the amplification result. The reference voltage Vref is generated by a reference voltage source (not shown), and temperature fluctuation thereof is minimized. The gain of the error amplifier circuit 223 is sufficiently large, and therefore, feedback control functions such that the output voltage Va of the differential amplifier circuit 222 and the reference voltage Vref become substantially equal to each other. Due to this feedback control, the voltage Vn between the nodes N3 and N4 is approximately expressed by the following expression.

$$Vn=(Vref-Vcom)/G \quad \ldots (2)$$

As can be seen from Expression (2), the voltage Vn between the nodes N3 and N4 is a constant value which is not affected by manufacturing variation of the impedance of the impedance element Z.

An operation of the sensor device 1 shown in Fig. 1 and having the configuration described above will be described.

As an example, it is assumed that the direction of a change in impedance with respect to the physical quantity of the detection target is reversed between the pair of the impedance elements Z1 and Z4 and the pair of the impedance elements Z2 and Z3. Specifically, for example, in a case where the physical quantity (a magnetic field or the like) of the detection target becomes large, the impedance increases in the pair of the impedance elements Z1 and Z4 and the impedance decreases in the pair of impedance elements Z2 and Z3. Conversely, in a case where the physical quantity (a magnetic field or the like) of the detection target becomes small, the impedance decreases in the pair of the impedance elements Z1 and Z4 and the impedance increases in the pair of impedance elements Z2 and Z3.

In a case where the physical quantity of the detection target becomes large, since the impedance of the impedance element Z3 is reduced and the impedance of the impedance element Z4 in increased, a voltage Vop of an intermediate node N6 (a node connecting the impedance elements Z3 and Z4) of the series circuit 11B rises. Further, since the impedance of the impedance element Z1 is increased and the impedance of the impedance element Z2 is reduced, the voltage Vop of each of the nodes N3 and N4 is lowered. Here, the voltage Vn between the nodes N3 and N4 is kept constant by the constant voltage circuit 22, and therefore, assuming that the voltage dividing ratio of the voltage dividing circuit 21 does not change, the voltage of the output node N5 with respect to the node N4 is kept constant. Accordingly, if the voltage of the node N4 is lowered, a voltage Von of the output node N5 is also lowered. From the above, since the voltage Vop rises and the voltage Von is lowered, an output voltage Vo (= Vop-Von) of the bridge circuit 10 changes in the positive direction.

In a case where the physical quantity of the detection target becomes small, since due to the operation reverse to the above, the voltage Vop is lowered and the voltage Von rises, the output voltage Vo of the bridge circuit 10 changes in the negative direction. In this manner, the output voltage Vo of the bridge circuit 10 changes according to the physical quantity of the detection target.

It is required that the output voltage Vo (the voltage between the intermediate node N6 of the series circuit 11B and the output node N5 of the voltage dividing circuit 21) of the bridge circuit 10 becomes a predetermined value (for example, zero) when the physical quantity of the detection target is the reference value. In the sensor device 1 according to this embodiment, the voltage dividing ratio of the voltage dividing circuit 21 is adjusted such that deviation (offset) of the output voltage Vo from this predetermined value becomes small. If the voltage dividing ratio of the voltage dividing circuit 21 is adjusted, the voltage Von of the output node N5 changes within the range from the voltage of the node N4 to the voltage of the output node N5. However, since the voltage Vn between the nodes N4 and N5 is controlled to be constant by the constant voltage circuit 22, the range of a change of the voltage Von, that is, the adjustment range of the offset of the output voltage Vo becomes always constant.

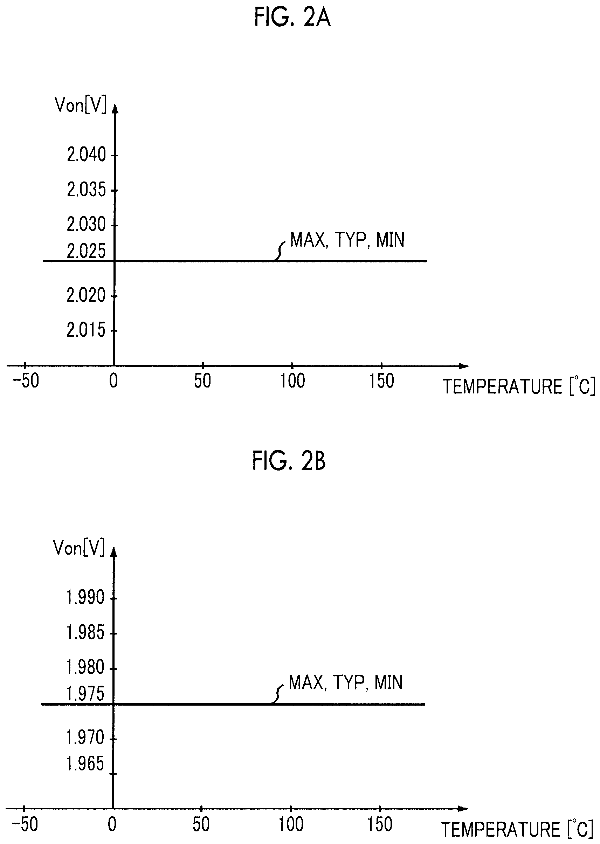

Figs. 2A and 2B are diagrams showing the simulation result of output performed on the sensor device 1 shown in Fig. 1 and show variation in the voltage Von of the output node N5 and a change in temperature. Fig. 2A shows an upper limit value in the adjustment range, and Fig. 2B shows a lower limit value in the adjustment range. In the simulation of Figs, 2A and 2B, the conditions of the same resistance values as the resistors 101, 102, 103, and 104 in the simulation of Figs. 5A and 5B are respectively applied to the impedance elements Z1, Z2, Z3, and Z4 of the bridge circuit 10 and the condition of the same resistance value as the variable resistor 105 is applied to the voltage dividing circuit 21. The power supply voltage VDD is 4 [V] which is the same as that in the simulation of Figs. 5A and 5B. The voltage Vn between the nodes N3 and N4 of the voltage dividing circuit 21 is controlled so as to become 0.05 [V] by the constant voltage circuit 22.

According to the simulation result of Figs. 2A and 2B, the graphs of "TYP", "MAX", and "MIN" representing the influence by variation in the resistance value of the impedance element Z almost coincide with each other. Accordingly, it can be seen that the adjustment range of the voltage Von hardly changes even if the manufacturing variation occurs in the resistance value of the impedance element Z. Further, it can be seen that even if the resistance values of the impedance elements Z1 and Z2 change according to a temperature, the voltage Von of the output node N5 is substantially constant and that the fluctuation of the offset voltage due to the temperature characteristic of the resistance is suppressed.

As described above, according to the sensor device 1 of this embodiment, the voltage Vn between the nodes N3 and N4 at both ends in the voltage dividing circuit 21 is kept constant. For this reason, even if manufacturing variation is present in the impedance of the four impedance elements Z, the range of change of the voltage Von of the output node N5 due to the adjustment of the voltage dividing ratio of the voltage dividing circuit 21 becomes substantially constant. In this way, also with respect to the output voltage Vo (the voltage between the intermediate node N6 and the output node N5) of the bridge circuit 10, the range of change due to the adjustment of the voltage dividing ratio becomes substantially constant. Accordingly, it is possible to keep the adjustment range of the offset of the output voltage Vo constant without being affected by the manufacturing variation of the impedance of the impedance element Z, and it is possible to suppress variation in the adjustment range as shown in the simulation result of Figs. 5A and 5B.

According to the sensor device 1 of this embodiment, since the temperature coefficients of impedance in the four impedance elements Z configuring the bridge circuit 10 are uniform, it is difficult for the ratio of the impedance in the four impedance elements Z to change according to a temperature. Further, since the constant power supply voltage VDD is supplied to the two nodes N1 and N2 and the voltage Vn between the nodes N3 and N4 at both ends in the voltage dividing circuit 21 is kept constant, if it is difficult for the ratio of the impedance in the four impedance elements Z to change according to a temperature, the voltage which is applied to the four impedance elements Z is also difficult to change according to a temperature. Accordingly, the offset of the output voltage Vo of the bridge circuit 10 becomes difficult to change according to a temperature, as shown in the simulation result of Figs. 5A and 5B. That is, even if the temperature of an environment changes, it becomes difficult for deviation of the offset adjustment to occur, and therefore, it is possible to detect a physical quantity with high accuracy in a wide temperature range.

According to the sensor device 1 of this embodiment, since the resistance value between the nodes N3 and N4 at both ends in the voltage dividing circuit 21 is constant and the voltage Vn between the nodes N3 and N4 is kept constant by the constant voltage circuit 22, the voltage which is applied to the impedance elements Z1 and Z2 does not change by the adjustment of the voltage dividing ratio and becomes substantially constant. In this way, the sensitivity of converting a change in physical quantity into a change in impedance in the impedance elements Z1 and Z2 is hardly affected by the adjustment of the voltage dividing ratio. That is, it becomes difficult for the adjustment of the offset of the output voltage Vo to affect the sensitivity of detection of a physical quantity, and thus it is possible to obtain good detection accuracy.

An embodiment of the present invention has been described above. However, the present invention is not limited to only the above-described embodiment and includes various variations.

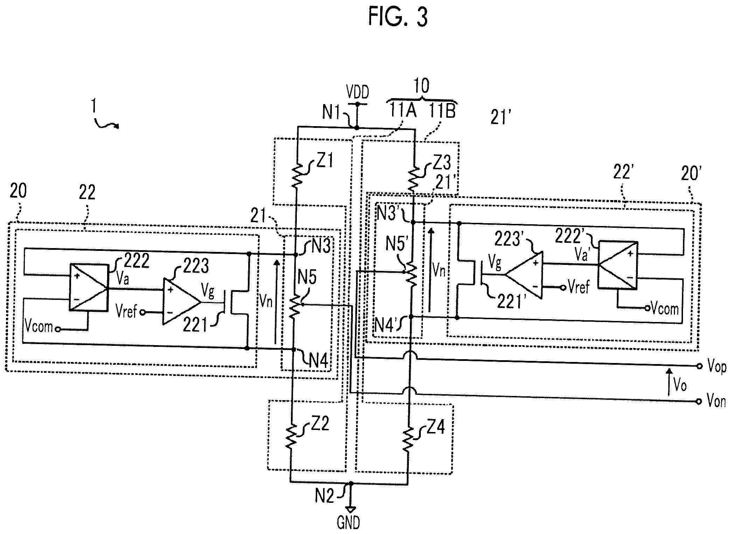

In the above-described embodiment, the offset adjustment circuit 20 is provided in only the series circuit 11A on one side out of the two series circuits 11A and 11B in the bridge circuit 10. However, the present invention is not limited thereto. In another embodiment shown in Fig. 3, the offset of the output voltage Vo may be adjusted by providing the offset adjustment circuit 20 in the series circuit 11A, providing a similar offset adjustment circuit 20' in the series circuit 11B, and adjusting the voltage dividing ratios of voltage dividing circuits 21 and 21' in the respective offset adjustment circuits 20 and 20'. That is, the voltage dividing ratio may be adjusted such that the voltage Vo between the output node N5 of the voltage dividing circuit 21 in the series circuit 11A on one side and an output node N5' on the other side of the voltage dividing circuit 21' on the other side in the series circuit 11B on the other side approaches a predetermined value. In this way, the voltages which are applied to the four impedance elements Z1 to Z4 become substantially equal to each other, and thus it becomes easy to make the sensitivities of detection of physical quantities in the respective impedance elements Z uniform. Therefore, it is possible to obtain better detection accuracy.

In the above-described embodiments, each of the four impedance elements Z in the bridge circuit 10 is a sensor element and has impedance according to the physical quantity of the detection target. However, the present invention is not limited thereto. In another embodiment of the present invention, some of a plurality of impedance elements configuring the bridge circuit may have a fixed impedance.

In the above-described embodiments, a constant voltage is applied to the nodes N1 and N2. However, in another embodiment of the present invention, a constant current may be supplied from a constant current source to the nodes N1 and N2.

It should be understood by those skilled in the art that various modifications, combinations, sub-combinations and alterations may occur depending on design requirements and other factors insofar as they are within the scope of the appended claims.

**Claims**

1. A sensor device (1) comprising:

   a bridge circuit (10) having a plurality of impedance elements (Z1, Z2, Z3, Z4), at least some of which have impedance according to a physical quantity of a detection target; and
   an offset adjustment circuit (20) for adjusting an offset of an output voltage of the bridge circuit (10),
   wherein the bridge circuit (10) has two series circuits (11A, 11B), each of which includes two or more of the impedance elements (Z1, Z2, Z3, Z4) connected in series between a node (N1) which is connected to a power supply line (VDD) and a node (N2) which is connected to a ground (GND),
   wherein the offset adjustment circuit (20) has a voltage dividing circuit (21) which is inserted between the impedance elements (Z1, Z2) in an intermediate pathway of a first series circuit (11A) of the two series circuits (11A, 11B) and is configured to divide a voltage between nodes (N3, N4) at both ends in the inserted intermediate pathway and output the divided voltage from an output node (N5),
   **characterised in that**
   the offset adjustment circuit (20) further includes a constant voltage circuit (22) which is configured to keep a voltage (Vn) between the nodes (N3, N4) at both ends in the voltage dividing circuit (21) constant,
   a voltage dividing ratio of the voltage dividing circuit (21) is adjustable, and
   the offset adjustment circuit (20) is configured to perform adjustment of the offset by adjusting the voltage dividing ratio such that the voltage between the output node (N5) of the voltage dividing circuit (21) in the first series circuit (11A) on one side and an intermediate node (N6) of a second series circuit (11B) of the two series circuits (11A, 11B) on the other side, approaches a predetermined value.

2. The sensor device (1) according to Claim 1, wherein the constant voltage circuit (22) includes a variable resistance element (221) which is connected in parallel with the voltage dividing circuit (21) and has a resistance value changing according to a control signal,
   a differential amplifier circuit (222) which is configured to amplify the voltage between the nodes (N3, N4) at both ends in the voltage dividing circuit (21), and

an error amplifier circuit (223) which is configured to amplify a difference between an output voltage of the differential amplifier circuit (222) and a reference voltage and output the control signal according to the amplification result.

3. The sensor device (1) according to Claim 2, wherein the differential amplifier circuit (222) is configured to output the voltage obtained by adding the voltage resulting from the amplification of the voltage (Vn) between the nodes (N3, N4) at both ends in the voltage dividing circuit (21) and a common mode voltage kept constant.

4. The sensor device (1) according to any one of Claims 1 to 3, wherein in the voltage dividing circuit (21), a resistance value between the nodes (N3, N4) at both ends is constant and a resistance value between the node (N3) on one side in the nodes (N3, N4) at both ends and the output node (N5) and a resistance value between the node (N4) on the other side in the nodes (N3, N4) at both ends and the output node (N5) are adjustable.

5. The sensor device (1) according to any one of Claims 1 to 4, wherein a constant voltage is supplied to the two nodes (N1, N2), and in the plurality of impedance elements (Z1, Z2, Z3, Z4), temperature coefficients of impedance are uniform.

6. The sensor device (1) according to claim 1, further comprises a second offset adjustment circuit (20') which has:

a second voltage dividing circuit (21') which is inserted between the impedance elements (Z3, Z4) in an intermediate pathway of a second series circuit (11B) of the two series circuits (11A, 11B) and is configured to divide a voltage between nodes (N3', N4') at both ends in the inserted intermediate pathway and output the divided voltage from an output node (N5'), and a second constant voltage circuit (22') which is configured to keep a voltage (Vn) between the nodes (N3', N4') at both ends in the second voltage dividing circuit (21') constant, wherein the second voltage dividing circuit (21') is configured to adjust the voltage dividing ratio of the second voltage dividing circuit (21') such that the voltage between the output node (N5) of the voltage dividing circuit (21) in the first series circuit (11A) on one side and an output node (N5') on the other side of the second voltage dividing circuit (21') on the other side in the second series circuit (11B) on the other side approaches the predetermined value.

7. The sensor device (1) according to claim 1, wherein the voltage dividing circuit (21) is configured to using a variable resistor.

## Patentansprüche

1. Sensorvorrichtung (1), die aufweist:

eine Brückenschaltung (10) mit einer Mehrzahl von Impedanzelementen (Z1, Z2, Z3, Z4), von denen mindestens einige eine Impedanz gemäß einer physikalischen Größe eines Detektionsziels haben; und
eine Offsetanpassungsschaltung (20) zum Anpassen eines Offsets einer Ausgangsspannung der Brückenschaltung (10),
wobei die Brückenschaltung (10) zwei Reihenschaltungen (11A, 11B) aufweist, von denen jede zwei oder mehr der Impedanzelemente (Z1, Z2, Z3, Z4) umfasst, die zwischen einen Knoten (N1), der mit einer Energieversorgungsleitung (VDD) verbunden ist, und einen Knoten (N2), der mit einer Masse (GND) verbunden ist, in Reihe geschaltet sind,
wobei die Offsetanpassungsschaltung (20) eine Spannungsteilungsschaltung (21) aufweist, die zwischen den Impedanzelementen (Z1, Z2) in einen dazwischenliegenden Pfad einer ersten Reihenschaltung (11A) der zwei Reihenschaltungen (11A, 11B) eingefügt ist und dazu ausgelegt ist, eine Spannung zwischen Knoten (N3, N4) an beiden Enden in dem eingefügten dazwischenliegenden Pfad zu teilen und die geteilte Spannung von einem Ausgangsknoten (N5) auszugeben,
**dadurch gekennzeichnet, dass**
die Offsetanpassungsschaltung (20) ferner eine Konstantspannungsschaltung (22) umfasst, die dazu ausgelegt ist, eine Spannung (Vn) zwischen den Knoten (N3, N4) an beiden Enden in der Spannungsteilungsschaltung (21) konstant zu halten,
ein Spannungsteilungsverhältnis der Spannungsteilungsschaltung (21) anpassbar ist und die Offsetanpassungsschaltung (20) dazu ausgelegt ist, eine Anpassung des Offsets durch Anpassen des Spannungsteilungsverhältnisses derart durchzuführen, dass sich die Spannung zwischen dem Ausgangsknoten (N5) der Spannungsteilungsschaltung (21) in der ersten Reihenschaltung (11A) auf einer Seite und einem Zwischenknoten (N6) einer zweiten Reihenschaltung (11B) der zwei Reihenschaltungen (11A, 11B) auf der anderen Seite einem vorbestimmten Wert annähert.

2. Sensorvorrichtung (1) nach Anspruch 1, wobei die Konstantspannungsschaltung (22) umfasst ein Element (221) mit variablem Widerstand, das zu der Spannungsteilungsschaltung (21) parallel geschaltet ist und einen Widerstandswert hat, der sich gemäß einem Steuersignal ändert, eine Differenzverstärkerschaltung (222), die dazu ausgelegt ist, die Spannung zwischen den Knoten (N3, N4) an beiden Enden in der Spannungsteilungsschaltung (21) zu verstärken, und eine Fehlerverstärkerschaltung (223), die dazu ausgelegt ist, eine Differenz zwischen einer Ausgangsspannung der Differenzverstärkerschaltung (222) und einer Referenzspannung zu verstärken und das Steuersignal gemäß dem Verstärkungsergebnis auszugeben.

**3.** Sensorvorrichtung (1) nach Anspruch 2, wobei die Differenzverstärkerschaltung (222) dazu ausgelegt ist, die Spannung auszugeben, die durch Addieren der aus der Verstärkung der Spannung (Vn) zwischen den Knoten (N3, N4) an beiden Enden in der Spannungsteilungsschaltung (21) resultierenden Spannung und einer konstant gehaltenen Gleichtaktspannung erlangt wird.

**4.** Sensorvorrichtung (1) nach einem der Ansprüche 1 bis 3, wobei in der Spannungsteilungsschaltung (21) ein Widerstandswert zwischen den Knoten (N3, N4) an beiden Enden konstant ist und ein Widerstandswert zwischen dem Knoten (N3) auf einer Seite in den Knoten (N3, N4) an beiden Enden und dem Ausgangsknoten (N5) und ein Widerstandswert zwischen dem Knoten (N4) auf der anderen Seite in den Knoten (N3, N4) an beiden Enden und dem Ausgangsknoten (N5) anpassbar ist.

**5.** Sensorvorrichtung (1) nach einem der Ansprüche 1 bis 4, wobei eine Konstantspannung an die zwei Knoten (N1, N2) geliefert wird und in der Mehrzahl von Impedanzelementen (Z1, Z2, Z3, Z4) Temperaturkoeffizienten von Impedanz einheitlich sind.

**6.** Sensorvorrichtung (1) nach Anspruch 1, die ferner eine zweite Offsetanpassungsschaltung (20') aufweist mit:

einer zweiten Spannungsteilungsschaltung (21'), die zwischen die Impedanzelemente (Z3, Z4) in einen dazwischenliegenden Pfad einer zweiten Reihenschaltung (11B) der zwei Reihenschaltungen (11A, 11B) eingefügt ist und dazu ausgelegt ist, eine Spannung zwischen Knoten (N3', N4') an beiden Enden in dem eingefügten dazwischenliegenden Pfad zu teilen und die geteilte Spannung von einem Ausgangsknoten (N5') auszugeben, und eine zweite Konstantspannungsschaltung (22'), die dazu ausgelegt ist, eine Spannung (Vn) zwischen den Knoten (N3', N4') an beiden Enden in der zweiten Spannungsteilungsschaltung (21') konstant zu halten, wobei die zweite Spannungsteilungsschaltung (21') dazu ausgelegt ist, das Spannungsteilungsverhältnis der zweiten Spannungsteilungsschaltung (21') derart anzupassen, dass sich die Spannung zwischen dem Ausgangsknoten (N5) der Spannungsteilungsschaltung (21) in der ersten Reihenschaltung (11A) auf einer Seite und einem Ausgangsknoten (N5') auf der anderen Seite der zweiten Spannungsteilungsschaltung (21') auf der anderen Seite in der zweiten Reihenschaltung (11B) auf der anderen Seite dem vorbestimmten Wert annähert.

**7.** Sensorvorrichtung (1) nach Anspruch 1, wobei die Spannungsteilungsschaltung (21) dazu ausgelegt ist, einen variablen Widerstand zu verwenden.

## Revendications

**1.** Dispositif de capteur (1), comprenant :

un circuit à pont (10) présentant une pluralité d'éléments d'impédance (Z1, Z2, Z3, Z4), parmi lesquels au moins certains présentent une impédance conformément à une quantité physique d'une cible de détection, et un circuit de réglage de décalage (20) pour régler un décalage d'une tension de sortie du circuit à pont (10) ; dans lequel le circuit à pont (10) présente deux circuits série (11A, 11B), chacun incluant deux éléments d'impédance ou plus (Z1, Z2, Z3, Z4) montés en série entre un nœud (N1), lequel est connecté à une ligne d'alimentation électrique (VDD), et un nœud (N2), lequel est connecté à une masse (GND), et dans lequel le circuit de réglage de décalage (20) présente un circuit de division de tension (21), lequel est introduit entre les éléments d'impédance (Zl, Z2) dans un trajet intermédiaire d'un premier circuit série (11A) parmi les deux circuits série (11A, 11B), et est configuré pour diviser une tension entre des nœuds (N3, N4) aux deux extrémités dans le trajet intermédiaire introduit, et produire la tension divisée à partir d'un nœud de sortie (N5), **caractérisé en ce que** le circuit de réglage de décalage (20) inclut en outre un circuit de tension constante (22), lequel est configuré pour maintenir une tension (Vn) constante entre les nœuds (N3, N4) aux deux extrémités dans le circuit de division de tension (21) ;

un rapport de division de tension du circuit de division de tension (21) est réglable, et

le circuit de réglage de décalage (20) est configuré pour réaliser un réglage du décalage en réglant le rapport de division de tension de telle sorte que la tension entre le nœud de sortie (N5) du circuit de division de tension (21) dans le premier circuit série (11A) sur un côté et un nœud intermédiaire (N6) d'un second circuit série (11B) parmi les deux circuits série (11A, 11B) sur l'autre côté se rapproche d'une valeur prédéterminée.

2. Dispositif de capteur (1) selon la revendication 1, dans lequel le circuit de tension constante (22) inclut :

un élément de résistance variable (221), lequel est monté en parallèle avec le circuit de division de tension (21) et présente une valeur ohmique variant conformément à un signal de commande ;

un circuit d'amplificateur différentiel (222), lequel est configuré pour amplifier la tension entre les nœuds (N3, N4) aux deux extrémités dans le circuit de division de tension (21), et

un circuit d'amplificateur d'erreurs (223), lequel est configuré pour amplifier une différence entre une tension de sortie du circuit d'amplificateur différentiel (222) et une tension de référence, et produire le signal de commande conformément au résultat d'amplification.

3. Dispositif de capteur (1) selon la revendication 2, dans lequel le circuit d'amplificateur différentiel (222) est configuré pour produire la tension obtenue en additionnant la tension résultant de l'amplification de la tension (Vn) entre les nœuds (N3, N4) aux deux extrémités dans le circuit de division de tension (21) et une tension de mode commun maintenue constante.

4. Dispositif de capteur (1) selon l'une quelconque des revendications 1 à 3, dans lequel dans le circuit de division de tension (21), une valeur ohmique entre les nœuds (N3, N4) aux deux extrémités est constante, et une valeur ohmique entre le nœud (N3) d'un côté dans les nœuds (N3, N4) aux deux extrémités et le nœud de sortie (N5) et une valeur ohmique entre le nœud (N4) sur l'autre côté dans les nœuds (N3, N4) aux deux extrémités et le nœud de sortie (N5) sont réglables.

5. Dispositif de capteur (1) selon l'une quelconque des revendications 1 à 4, dans lequel une valeur constante est fournie aux deux nœuds (N1, N2), et dans la pluralité d'éléments d'impédance (Z1, Z2, Z3, Z4), des coefficients de température d'impédance sont uniformes.

6. Dispositif de capteur (1) selon la revendication 1, comprenant en outre un second circuit de réglage de décalage (20'), lequel présente :

un second circuit de division de tension (21'), lequel est introduit entre les éléments d'impédance (Z3, Z4) dans un trajet intermédiaire d'un second circuit série (11B) des deux circuits série (11A, 11B) et est configuré pour diviser une tension entre des nœuds (N3', N4') aux deux extrémités dans le trajet intermédiaire introduit, et produire la tension divisée à partir d'un nœud de sortie (N5'), et

un second circuit de tension constante (22'), lequel est configuré pour maintenir une tension (Vn) constante entre les nœuds (N3', N4') aux deux extrémités dans le second circuit de division de tension (21'),

dans lequel le second circuit de division de tension (21') est configuré pour régler le rapport de division de tension du second circuit de division de tension (21') de telle sorte que la tension entre le nœud de sortie (N5) du circuit de division de tension (21) dans le premier circuit série (11A) sur un côté et un nœud de sortie (N5') sur l'autre côté du second circuit de division de tension (21') sur l'autre côté dans le second circuit série (11B) sur l'autre côté se rapproche d'une valeur prédéterminée.

7. Dispositif de capteur (1) selon la revendication 1, dans lequel le circuit de division de tension (21) est configuré pour utiliser une résistance variable.

FIG. 1

## FIG. 2A

## FIG. 2B

FIG. 3

FIG. 4

## FIG. 5A

## FIG. 5B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1311284 A
- US 4911016 A
- US 5460050 A